# EUROPEAN PATENT APPLICATION

(11) **EP 4 610 613 A1**
(43) Date of publication of application: **03.09.2025**
(21) Application number: 25157426.5
(22) Date of filing: 12.02.2025
(51) Int. Cl.: G01L 9/00, G01L 19/00, G01L 19/06

(54) **MICROELECTROMECHANICAL SENSOR WITH IMPROVED EXTERNAL FLUIDIC COUPLING AND MANUFACTURING PROCESS THEREOF**

(30) Priority: 29.02.2024 IT 202400004465
(71) Applicant: STMicroelectronics International N.V., 1228 Plan-les-Ouates, Geneva (CH)
(72) Inventor: TENTORI, Lorenzo, 20843 VERANO BRIANZA (MB) (IT); AZPEITIA URQUIA, Mikel, 20128 Milano (IT)
(74) Representative: Studio Torta S.p.A.

(57) **Abstract**

A microelectromechanical sensor (50) includes: a supporting body (2), containing semiconductor material; a sensing structure (6), comprising a measuring chamber (9) and a sensitive element (8), the sensitive element (8) being formed at least partially in the supporting body (2) and facing the measuring chamber (9); and a cap (3), of semiconductor material, coupled to the supporting body (2) and having an internal surface (3a), arranged facing the supporting body (2), and an external surface (3b), opposite to the internal surface (3a) along a first direction (Z). The cap (3) comprises a buried cavity (60), a plurality of inlet holes (5), communicating with the environment external to the sensor and with the buried cavity (60), and a plurality of coupling holes (15), communicating with the measuring chamber (9) and with the buried cavity (60). The plurality of inlet holes (5) is in fluidic communication with the plurality of coupling holes (15) by the buried cavity (60), and the inlet holes (5) are offset with respect to the coupling holes (15).

## Description

### Technical Field

The present invention relates to a microelectromechanical sensor with improved external fluidic coupling and to the manufacturing process thereof.

### Background

Environmental quantity sensors, such as MEMS (microelectromechanical) barometric pressure sensors, humidity sensors, gas and chemical detectors and sensors, and flow sensors, generally comprise a sensing element packaged in a case and connected to the external environment through one or more inlet holes in the case and internal fluidic paths, to receive the quantity to be measured. In MEMS pressure sensors, for example, the sensing element is often defined by a membrane that is deformable in response to variations in external pressure: in this case, a pressure signal may be read, in a capacitive or resistive manner, with respect to a/an (internal) reference pressure. Inlet holes and internal fluidic paths allow external pressure variations to propagate to the sensing element.

Typically, the inlet holes are provided in peripheral regions of the case, or in any case at a distance from the sensing element, which is in general positioned in a central region of the sensor; for example, the inlet holes may be organized in rows along the edges of the case. Such a positioning of the inlet holes is preferable as it reduces the risk that, during the formation of the same, the etching (e.g., chemical etching) steps damage the sensitive surfaces of the sensing element.

However, in the final steps of the manufacturing process of the sensor, and in particular in the steps of dicing the wafers and packaging, there is a risk that the inlet holes obstruct - even only partially - due, for example, to the migration of co-molding resins (a phenomenon known as "clogging"). Furthermore, again during the final steps of the manufacturing process, and in any case during the average life of the sensor, potentially harmful particles, such as grains of dust, may reach the sensing element of the sensor through the inlet holes and the internal fluidic paths. Contaminating particles may affect the functionalities of the sensor, for example by modifying the capacitances between conductive paths and/or creating drifts of the sensing elements.

To overcome these issues, a dedicated design of the inlet holes is often used, both in terms of position and in terms of number and dimensions (for example, diameters equal to 10µm). However, there are constraints that may limit the effectiveness of measures of this kind. For example, reducing the number of inlet holes may not be compatible with the desirable redundancy for this type of sensors, while too small dimensions may even more easily cause obstruction of the inlet holes.

### Summary

It is therefore an aim of the present invention to overcome or at least in part mitigate the disadvantages and limitations of the state of the art.

According to the present invention, a microelectromechanical sensor with external fluidic coupling and the manufacturing process thereof are provided as defined in the attached claims.

### Brief Description of the Figures

For a better understanding of the present invention, preferred embodiments are provided, by way of non-limiting example, with reference to the attached drawings, wherein:
- Figure 1 schematically shows, in a cross-section, a MEMS sensor in accordance with an embodiment of the present invention;
- Figure 2 schematically shows, in a top-plan view, the MEMS sensor of Figure 1;
- Figure 3 schematically shows in a cross-section a MEMS sensor in accordance with a different embodiment of the present invention;
- Figures 4-8 schematically show, in top-plan views, different embodiments of a component of the MEMS sensor of Figure 3;
- Figures 9a-9d schematically show, along the same cross-section of Figure 3, consecutive steps of a manufacturing process of the MEMS sensor of Figure 3 in accordance with an embodiment of the present invention; and
- Figures 10a-10g schematically show, along the same cross-section of Figure 3, consecutive steps of a manufacturing process of the MEMS sensor of Figure 3 in accordance with a different embodiment of the present invention.

### Description of Embodiments

The following description refers to the arrangement shown in the drawings; consequently, expressions such as "above", "below", "upper", "lower", "top", "bottom", "right", "left" and the like relate to the attached Figures and are not to be interpreted in a limiting manner.

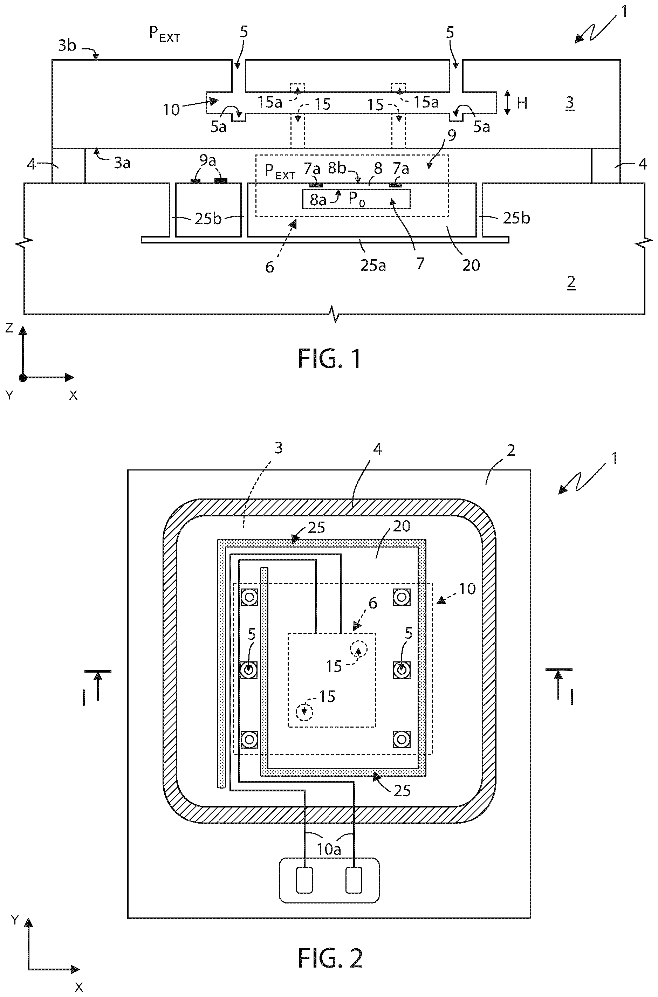

Figures 1 and 2 illustrate a portion of a microelectromechanical (MEMS) sensor with external fluidic coupling, for example a barometric pressure sensor (or simply, pressure sensor), in accordance with an embodiment of the present invention and indicated as a whole with the number 1. The pressure sensor 1 comprises a supporting body 2, containing semiconductor material (for example intrinsic and/or doped silicon), and a cap 3, also of semiconductor material. The cap 3 overlies the supporting body 2 and has an internal surface 3a, arranged facing the supporting body 2, and an external surface 3b opposite to the internal surface 3a. The cap 3 is also bonded to the supporting body 2 by a bonding ring 4. A thickness of the bonding ring determines a distance between the cap 3 and the supporting body 2. Considering a reference system of orthogonal axes X, Y, Z, the supporting body 2 and the cap 3 have a substantially planar shape parallel to the XY plane and are stacked in the direction of the Z axis.

The supporting body 2 accommodates a sensing structure 6 which occupies a substantially central position in the pressure sensor 1. The sensing structure 6 is in communication with the environment external to the pressure sensor 1 through the cap 3, as explained below. In practice, the supporting body 2, the cap 3 and the bonding ring 4 delimit a volume which is accessible from the outside through the cap 3, allowing an external pressure P_{EXT} (for example the atmospheric pressure) and/or other physical parameters (such as, for example, humidity) to reach the supporting body 2.

The sensing structure 6 comprises in detail: a reference chamber 7, permanently sealed with respect to the external environment and maintained at a reference pressure (internal pressure, P₀); a membrane 8 of semiconductor material, which delimits on one side the reference chamber 7; and a measuring chamber 9, extending above the membrane 8 on a side opposite to the reference chamber 7 and in fluidic coupling with the external environment. Even more in detail, the membrane 8 is interposed between the reference chamber 7 and the measuring chamber 9 and has a lower face 8a, arranged facing the reference chamber 7, and an upper face 8b, arranged facing the measuring chamber 9. The reference chamber 7 is a cavity buried in the supporting body 2.

The membrane 8 is suspended on the reference chamber 7 so that the deformations of the membrane 8 may occur along the direction parallel to the Z axis and therefore perpendicularly to the supporting body 2: as the external pressure P_{EXT} varies with respect to the reference pressure P₀ of the reference chamber 7, i.e. as the pressure on the upper face 8b varies, the membrane 8 is free to deform and the deformation may be read by exploiting electrical phenomena. For example, the membrane 8 is provided with piezoelectric sensing structures - comprising implanted piezoresistances 7a - which respond to deformations of the same membrane 8. In an alternative embodiment (not shown), the membrane 8, that is conductive and suitably insulated from the supporting body 2, may be capacitively coupled to reference electrodes placed at the base of the reference chamber 7; in this case, an offset of the lower face 8a of the membrane 8 causes a variation in the capacitive coupling detectable at external terminals.

The pressure sensor 1 comprises a platform (also known as "decoupling mass") 20 which at least partially accommodates the sensing structure 6. The platform 20 is suspended with respect to the supporting body 2 by flexures (not shown in Figures 1 and 2) and is separated from the supporting body 2 by a separation region 25. In a non-limiting embodiment, the separation region 25 is a trench which surrounds the platform 20 and has a substantially spiral shape in sections along planes parallel to the XY plane. A first portion 25a of the separation region 25 extends below and at least for the entire dimension of the platform 20. Second portions 25b of the separation region 25 extend transversely to the first portion 25a (here parallel to the Z axis) and are communicating therewith. Conductive lines 9a for connecting the pressure sensor 1 extend, for example, above the platform 20. The platform 20 improves the rejection of thermomechanical stresses, due for example to the packaging steps and/or the soldering steps of the pressure sensor 1.

The cap 3 comprises, in detail, a plurality of inlet holes 5, a buried rerouting cavity 10 and a plurality of coupling holes 15.

The inlet holes 5 are arranged, for example, around the sensing structure 6 and extend along the Z axis from the external surface 3b of the cap 3 to the rerouting cavity 10. The inlet holes 5 then couple the rerouting cavity 10 directly to the environment external to the pressure sensor 1. In a non-limiting embodiment, the inlet holes 5 have a circular section and are organized in two rows parallel to the Y axis. The coupling holes 15 extend along the Z axis from the internal surface 3a of the cap 3 to the reroutig cavity 10 and communicate with the measuring chamber 9 of the sensing structure 6. In a non-limiting embodiment, the coupling holes 15 have a circular section and are misaligned with respect to the inlet holes 5. For example, the coupling holes 15 overlay the sensing structure 6 and are arranged in more internal positions of the pressure sensor 1, along the X axis and/or the Y axis, with respect to the inlet holes 5.

The rerouting cavity 10 is buried in the cap 3 and puts the plurality of inlet holes 5 in communication with the plurality of coupling holes 15. In detail, the rerouting cavity 10 extends at least partially over the sensing structure 6 and the platform 20: for example, the rerouting cavity has a dimension along the X axis comprised between 50pm and 1mm and a dimension along the Y axis comprised between 50pm and 1mm. The rerouting cavity 10 also has a height H along the Z axis, comprised for example between 100nm and 10µm. In a non-limiting embodiment, the rerouting cavity 10, moreover, extends parallel to the XY plane and protrudes laterally with respect to the inlet holes 5.

Each inlet hole 5 puts the environment external to the pressure sensor 1 in communication with the rerouting cavity 10. Each coupling hole 15 puts the rerouting cavity 10 in communication with the measuring chamber 9 of the sensing structure 6. As already mentioned, moreover, the inlet holes 5 are misaligned with respect to the coupling holes 15, so as not to have substantially straight and direct paths from the external environment to the measuring chamber 9. In one embodiment, in particular, projections of the inlet holes 5 and the coupling holes 15 on the XY plane are disjoint. The measuring chamber 9 of the sensing structure 6 is therefore in communication with the environment external to the pressure sensor 1 through non-straight fluidic paths defined by the inlet holes 5, the rerouting cavity 10 and the coupling holes 15. Such a fluidic coupling provided by the rerouting cavity 10 is more robust against contamination of the sensing structure 6 by undesired particles owing to the absence of a direct straight path (along the Z axis) between the inlet holes 5 and the coupling holes 15, i.e. between the environment external to the pressure sensor 1 and the measuring chamber 9.

The rerouting cavity 10 of the pressure sensor 1 also comprises vertical traps that form collection reservoirs for the contaminating particles entering the pressure sensor 1 through the inlet holes 5. In detail, first vertical traps 15a extend along the Z axis, towards the external surface 3b of the cap 3, in positions corresponding to respective coupling holes 15; second vertical traps 5a extend along the Z axis, towards the internal surface 3a of the cap 3, in positions corresponding to respective inlet holes 5. In practice, and as described below, each first vertical trap 15a is a continuation of a respective coupling hole 15 through and beyond the rerouting cavity 10; each second vertical trap 5a is a continuation of a respective inlet hole 5 through and beyond the rerouting cavity 10. In a non-limiting embodiment, the first and the second vertical traps 15a, 5a have, respectively, the same section along planes parallel to the XY plane of respective coupling holes 15a and respective inlet holes 5.

The depth of the first and the second vertical traps 15a, 5a and the height H of the rerouting cavity are design parameters of the pressure sensor 1 with respect to reducing the probability that contaminating particles coming from the external environment reach the sensing structure 6.

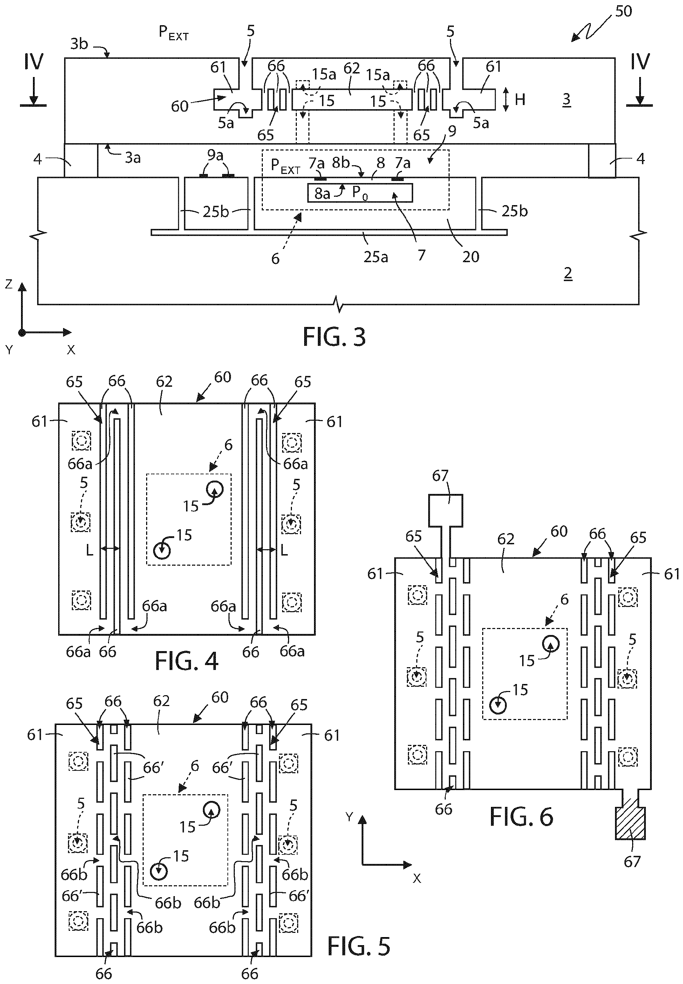

Figures 3 and 4 illustrate a pressure sensor in accordance with a different embodiment of the present invention and indicated as a whole with the number 50. Elements of Figures 3 and 4 which correspond to elements of Figures 1 and 2 are illustrated with same reference numbers. Furthermore, the pressure sensor 50 is described below with reference to the differences with respect to the pressure sensor 1.

The cap 3 of the pressure sensor 50 accommodates a rerouting cavity 60 and filtering structures 65, accommodated into the rerouting cavity 60 and configured to limit the entrance of contaminating particles coming from the external environment. In detail, the filtering structures 65 comprise walls which extend through the rerouting cavity 60 and define obstacles for the passage of solid bodies between the plurality of inlet holes 5 and the plurality of coupling holes 15, without the inlet holes 5 to be fluidically decoupled from the coupling holes 15. The filtering structures 65 define, in the rerouting cavity 60, inlet regions 61, facing and directly communicating with respective inlet holes 5, and a coupling region 62, facing and directly communicating with the coupling holes 15; each inlet region 61 communicates with the coupling region 62 by a respective filtering structure 65.

In the pressure sensor 50, the measuring chamber 9 of the sensing structure 6 is in communication with the external environment through tortuous fluidic paths defined by the filtering structures 65. Some possible embodiments of the filtering structures 65 are described below, by way of example (therefore not to be understood in a limiting or exhaustive manner).

The rerouting cavity 60 of Figures 3 and 4 comprise a pair of filtering structures 65 that are distinct and identical and arranged so that, in the plan-view of Figure 4, the sensing structure 6 is comprised between the filtering structures 65. Each filtering structure 65 is defined by a plurality of barrier elements 66 (three shown in Figures 3 and 4) formed of the same material as the cap 3, for example monocrystalline silicon. The barrier elements 66 of each filtering structure 65 extend in an elongated shape parallel to the Y axis and are offset to each other along the X axis by a pitch L. More in detail, the barrier elements 66 extend parallel to the Y axis with a dimension smaller than the dimension, along the Y axis, of the rerouting cavity 60; furthermore, adjacent barrier elements 66 are defined starting from opposite walls (and parallel to the X axis) of the rerouting cavity 60. Fluidic openings 66a are therefore present between the barrier elements 66 of a same filtering structure 65. Fluidic openings 66a at external ends - with respect to the sensing structure 6 - of each filtering structure 65 are in communication with the respective inlet region 61; fluidic openings 66a at internal ends of each filtering structure 65 are in communication with the coupling region 62. In a non-limiting embodiment, the barrier elements 66 extend parallel to the Z axis for the entire height H of the rerouting cavity 60.

The fluidic openings 66a of the filtering structures 65 allow the quantity to be measured to reach the sensing structure 6; at the same time, the barrier elements 66 introduce a high resistance to the passage of contaminating particles. The dimensions of the openings 66a, the pitch L between the barrier elements 66 and the height H of the rerouting cavity 60 are in fact design parameters of the pressure sensor 50 with respect to the desired filtering capacity. For example, the openings 66a have a dimension along the Y axis < 1µm. In practice, the barrier elements 66 of the filtering structures 65 are integrated into the cap 3 and, more in particular, into the rerouting cavity 60.

Figure 5 shows a different embodiment of the filtering structures 65 of the rerouting cavity 60. In particular, only the differences with respect to the embodiment of Figure 4 are shown. More in detail, the barrier elements 66 extend, parallel to the Y axis, from side to side of the rerouting cavity 60, each barrier element 66 being divided into portions 66' separated from each other along the Y axis; respective fluidic openings 66b are present between adjacent portions 66' of a same barrier element 66. Fluidic openings 66b corresponding to adjacent barrier elements 66 are also offset parallel to the Y axis so as to avoid the presence of direct fluidic sections. The fluidic openings 66b of barrier elements 66 which are at the external ends - with respect to the sensing structure 6 - of each filtering structure 65 are in communication with the respective inlet region 61; the fluidic openings 66b of barrier elements 66 which are at the internal ends of each filtering structure 65 are in communication with the coupling region 62.

The filtering structures 65 of Figure 5, by creating a redundancy, reduce the probability that obstruction phenomena of the fluidic paths occur in the rerouting cavity 60. The dimensions of the fluidic openings 66b are design parameters with respect to the desired filtering capacity. In a non-limiting embodiment, the fluidic openings 66b have dimensions along the Y axis that are equal to each other.

Figure 6 shows another embodiment of the filtering structures 65 and, more generally, of the rerouting cavity 60. In particular, only the differences with respect to the embodiment of Figure 5 (or with respect to the embodiment of Figure 4) are shown. More in detail, the rerouting cavity 60 comprises trapping elements 67 which form collection reservoirs for the contaminating particles entering the pressure sensor 50 through the inlet holes 5 and/or for the contaminating particles present in the fluidic paths. The trapping elements 67 communicate directly with the rerouting cavity 60 with respect to which they are extensions parallel to the XY plane ("in-plane" trapping elements) and, optionally, also in the direction of the Z axis ("out-of-plane" trapping elements), as shown in Figure 6. In a non-limiting embodiment, the trapping elements 67 are defined both between the barrier elements 66 and directly in communication with a respective inlet region 61. In practice, the trapping elements 67 are formed simultaneously with the rerouting cavity 60 and/or the filtering structures 65.

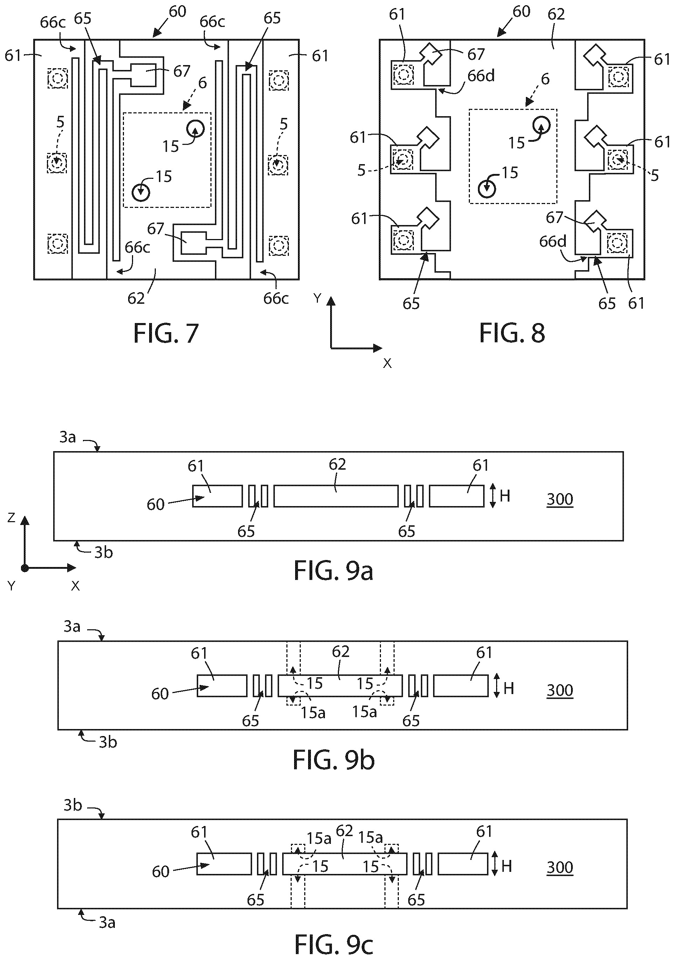

Figure 7 shows a further embodiment of the filtering structures 65 of the rerouting cavity 60. In particular, only the differences with respect to the embodiments of Figures 4-6 are shown. More in detail, the filtering structures 65 comprise trenches which develop, in the XY plane, according to a serpentine profile (i.e., with folded arms) similar to that defined by the barrier elements 66 of Figure 4 and with a depth equal to height H of the rerouting cavity 60. The filtering structures 65 are in communication, on one side, with the respective inlet region 61 and, on the opposite side (in the direction of the X axis), with the coupling region 62, through fluidic openings 66c. The filtering structures 65 may also comprise trapping elements 67 along the fluidic path, for example "in-plane" trapping elements, also defined according to the profile shown in Figure 6. In the embodiment of Figure 7, the serpentine profile of the filtering structures 65 - in terms of overall length and passage section - determines its filtering capacity.

Finally, with reference to Figure 8, in one embodiment of the pressure sensor 50, the inlet holes 5 communicate with respective inlet regions 61 of the rerouting cavity 60. The inlet regions 61 are portions of the rerouting cavity 60 defined by cells fluidically communicating with a coupling region 62 through respective fluidic openings 66d; each fluidic opening 66d creates a fluidic path between a respective inlet hole 5 and the plurality of coupling holes 15. The fluidic openings 66d may be defined by straight sections whose section determines the filtering capacity (for example, a dimension along the Y axis < 1µm); in an embodiment not shown, each fluidic opening 66d is defined by a section having folded arms. The filtering structures 65 of Figure 8 also comprise trapping elements 67, for example defined by further cells fluidically communicating each with a respective inlet region 61 and a respective inlet hole 5; the fluidic openings 66d show a high resistance to the passage of contaminating particles, while the trapping elements 67 show a high capacity to retain them.

Ultimately, by forming a rerouting cavity buried in the cap, the MEMS pressure sensor of the present invention has advantages in terms of design flexibility of the fluidic coupling of the sensing structure with the external environment. In particular, the sensor of the present invention is free of through holes that may form direct straight paths through the cap: the decentralization between inlet holes (communicating with the external environment) and coupling holes (communicating with the sensing structure) allows in fact the inlet holes to be defined in more central positions of the sensor and therefore the probability of obstruction phenomena to be significantly reduced during the packaging steps. Furthermore, filtering structures may be directly integrated into the rerouting cavity and therefore the risk of contaminations from the external environment may be reduced, without making modifications to the sensing structure. In particular, three-dimensional filtering structures may be created with shapes and dimensions as desired, obtaining filtering capacities that are high (< 1pm) and independent of the positioning and dimensions of the inlet holes. The filtering structures may finally cooperate with trapping elements of the rerouting cavity, i.e. collection reservoirs for contaminating particles. The contaminating particles coming from the external environment, therefore, tend to accumulate in dedicated positions and are further hindered in a possible route towards the sensing structure. In the pressure sensor, the probability that contaminating particles deposit in proximity to the membrane of the sensing structure is therefore significantly reduced, limiting variations in the electromechanical parameters during the life of the sensor. The pressure sensor of the present invention ultimately has more reliable measuring performance and repeatability.

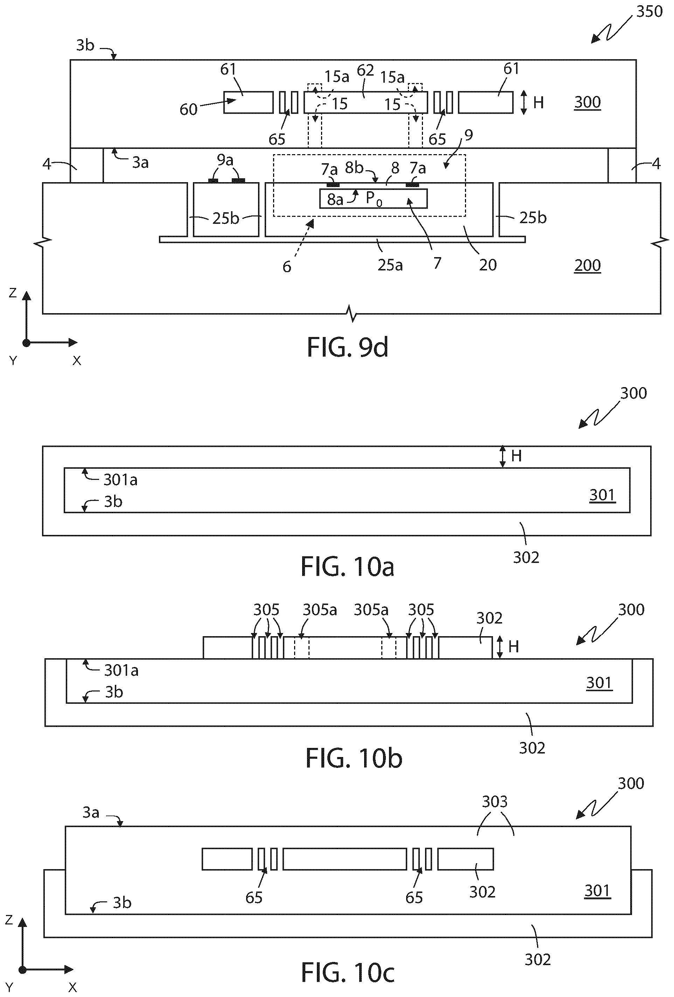

The rerouting cavity of the present invention may be formed during the manufacturing process of the pressure sensor cap, as briefly shown in the embodiments of Figures 9a-9d and Figures 10a-10g. Hereinafter, reference is made to the rerouting cavity 60, i.e. comprising filtering structures 65, according to any of the embodiments of Figures 4-8, but same manufacturing considerations also apply to the rerouting cavity 10 of Figure 1.

The manufacturing process of the rerouting cavity 60 according to the possible embodiments described below is independent of the manufacturing process of a sensor wafer 200, of semiconductor material, intended to comprise the supporting body 2 and the respective components. Furthermore, starting from a cap wafer 300, for example of monocrystalline silicon and intended to comprise the cap 3, the variants described below share the same order of execution of the steps of: defining the filtering structures 65 (if any); forming the plurality of coupling holes 15; subjecting to wafer flipping the cap wafer 300; bonding to the sensor wafer 200; and forming the plurality of inlet holes 5.

With reference to Figures 9a-9d, the rerouting cavity 60 and the integrated filtering structures 65 are created in the cap wafer 300, according to one embodiment of the manufacturing process of the present invention.

In detail, the rerouting cavity 60 is created (Figure 9a) by not-shown etching, epitaxial growth and annealing steps: in the etching step (for example an SF₆ plasma etching) the filtering structures 65 and, in regions corresponding to the inlet regions 61 and to the coupling region 62, structures separated by trenches (for example walls or pillars) may be defined; during the epitaxial growth, the trenches close without being filled; and during the annealing step (for example, an H₂ annealing step) the silicon redistributes forming the inlet regions 61 and the coupling region 62 of the rerouting cavity 60. Following the annealing step, the filtering structures 65 resulting from the etching step have dimensions determined by design preferences. During the processing steps leading to the cap wafer 300 of Figure 9a, the cap wafer 300 has an orientation (along the Z axis) that is flipped with respect to the final orientation of the cap 3 of Figure 3, so that the internal surface 3a overlies the external surface 3b.

Therefore, referring to Figure 9b, exploiting a special mask (not shown) applied to the internal surface 3a, the cap wafer 300 is selectively etched (for example by anisotropic etchings) at least to the rerouting cavity 60 so as to define the plurality of coupling holes 15. The first vertical traps 15a may also be formed, with the same mask, as a continuation of the aforementioned selective etching of the internal surface 3a beyond the rerouting cavity 60, for example with an anisotropic time-etching.

Successively, the cap wafer 300 is subject to wafer flipping assuming the final orientation of the cap 3, as shown in Figure 9c. The suspended platform 20, the sensing structure 6 and the conductive lines 9a are formed in the sensor wafer 200, separately. The cap wafer 300 is then bonded to the sensor wafer 200, by the bonding ring 4 (step known as "wafer-to-wafer bonding" - Figure 9d); such bonding is referred to as composite wafer 350 and it is understood that it is performed along the direction of the Z axis (the composite wafer 350 is shown in a same cross-section of the pressure sensor 50 of Figure 3) . Known grinding and trimming processes of the composite wafer 350 and, in particular, of the external surface 3b of the cap wafer 300 then follow.

Finally, exploiting a special mask (not shown) applied to the external surface 3b, the cap wafer 300 is selectively etched (for example by anisotropic etchings) at least to the rerouting cavity 60 so as to define the plurality of inlet holes 5 and thus putting the sensing structure 6 in fluidic communication with the external environment. The second vertical traps 5a may also be formed, with the same mask, as a continuation of the aforementioned selective etching of the external surface 3b beyond the rerouting cavity 60, for example with an anisotropic time-etching.

The final steps of the manufacturing process then follow, including the definition of external contacts and pads useful for extracting signals and the dicing operations of the composite wafer 350, thereby obtaining the pressure sensor 50 of Figure 3.

It is understood that the pressure sensor 1 of Figure 1 may be obtained by following the same steps of the manufacturing process as in Figures 9a-9d and described above, except for the etching step leading to the definition of the cap wafer 300 of Figure 9a (i.e., the filtering structures 65 are absent).

With reference to Figures 10a-10g, according to a different embodiment of the manufacturing process of the present invention, the rerouting cavity 60 and the integrated filtering structures 65 are created in the cap wafer 300.

In detail, the cap wafer 300 initially comprises a substrate 301, for example of monocrystalline silicon, which has a front side 301a and a back side which defines the external surface 3b of the cap 3. The substrate 301 is subject to an oxidation process (Figure 10a) and is covered at least on the front side 301a by a sacrificial layer 302, for example of silicon oxide; in a non-limiting embodiment, the sacrificial layer 302 coats the substrate 301 in its entirety. The sacrificial layer 302 is formed with a thickness coincident with the height H of the rerouting cavity 60 to be formed.

Successively, the sacrificial layer 302 is selectively etched and defined (Figure 10b) on the front side 301a of the substrate 301. In particular, first trenches 305 are opened in the sacrificial layer 302 along the profile of the filtering structures 65 to be formed; second trenches 305a are opened in the sacrificial layer 302 in positions corresponding to the coupling holes 15, and therefore to the first vertical traps 15a where present in the cap 3; the first and the second trenches 305, 305a leave respective portions of the substrate 301 exposed. The sacrificial layer 302 is removed on the remaining front side 301a of the substrate 301 while it is maintained in the corresponding position and for the entire dimension of the rerouting cavity 60 to be formed (Figures 10a-10f show the same cross-section as Figure 3).

A structural layer 303 is then formed, for example again of silicon, in contact with the substrate 301 and with the sacrificial layer 302 (Figure 10c). The structural layer 303 may be grown in an epitaxial reactor starting from the semiconductor material of the substrate 301 and from a seed layer covering the sacrificial layer 302 (not shown for simplicity); the structural layer 303 therefore fills the first and the second trenches 305, 305a. In detail, the structural layer 303 which is formed in contact with the substrate 301 is continuous therewith and identical from the point of view of the crystallographic shape. The structural layer 303 formed in the first and second trenches 305, 305a and thereabove is therefore, for example, of monocrystalline silicon. The structural layer 303 which is formed in contact with the sacrificial layer 302 is instead, for example, of polycrystalline silicon. During the step of Figure 10c, the material that fills the first trenches 305 forms the filtering structures 65. The substrate 301 and the structural layer 303 together thus form the cap wafer 300 (flipped with respect to the final orientation of the cap 3 of Figure 3, so that the internal surface 3a overlies the external surface 3b). A free face of the structural layer 303 defines the internal surface 3a of the cap wafer 300.

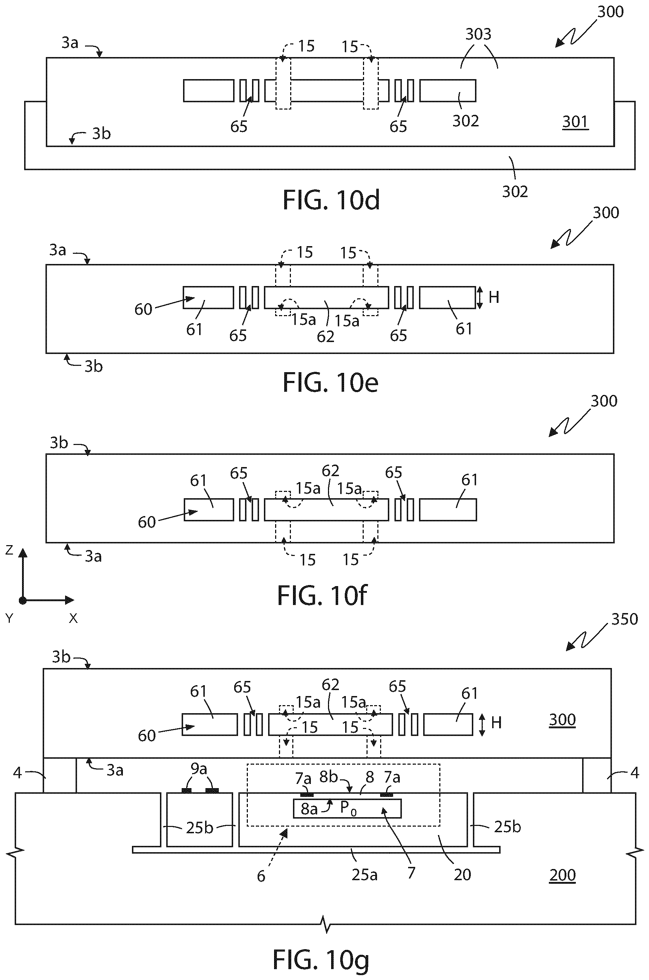

Therefore, referring to Figure 10d, exploiting a special mask (not shown) applied to the internal surface 3a, the structural layer 303 is selectively etched (for example by dry etching) at least to the substrate 301 so as to define the plurality of coupling holes 15. The first vertical traps 15a may also be formed, with the same mask, as a continuation of the aforementioned selective etching of the internal surface 3a in the substrate 301, for example with a time-etching. The selectivity of the etching is ensured by the difference in material of the structural layer 303 and the sacrificial layer 302.

Subsequently, the remaining sacrificial layer 302 (comprised between the structural layer 303 and the substrate 301 and coating the substrate 301) is removed, for example by a hydrofluoric acid selective etching, thus releasing the rerouting cavity 60 (Figure 10e), and in particular the inlet regions 61 and the coupling region 62.

Successively, the cap wafer 300 is subject to wafer flipping assuming the final orientation of the cap 3, as shown in Figure 10f. The sensor wafer 200 is processed, separately, in order to form the suspended platform 20, the sensing structure 6 and the conductive lines 9a. The cap wafer 300 is then bonded to the sensor wafer 200, by the bonding ring 4 (step known as "wafer-to-wafer bonding" - Figure 10g); such bonding is referred to as composite wafer 350 and it is understood that it is performed along the direction of the Z axis. Known grinding and trimming processes of the composite wafer 350 and, in particular, of the external surface 3b of the cap wafer 300 then follow.

Finally, exploiting a special mask (not shown) applied to the external surface 3b, the cap wafer 300 is selectively etched (for example by anisotropic etchings) at least to the rerouting cavity 60 so as to define the plurality of inlet holes 5 and thus putting the sensing structure 6 in fluidic communication with the external environment. The second vertical traps 5a may also be formed, with the same mask, as a continuation of the aforementioned selective etching of the external surface 3b beyond the rerouting cavity 60, for example with an anisotropic time-etching.

The final steps of the manufacturing process then follow, including the definition of external contacts and pads useful for extracting signals and the dicing operations of the composite wafer 350, thereby obtaining the pressure sensor 50 of Figure 3.

It is understood that the pressure sensor 1 of Figure 1 may be obtained by following the same steps of the manufacturing process as in Figures 10a-10g, except for the etching step leading to the definition of the sacrificial layer 302 of Figure 10b (i.e., the first trenches 305 are absent).

It is also understood that the filtering structures 65 similar to those of Figures 4-6 and which implement comparable filtering capacities, may be formed in a manner complementary to what has been shown.

The manufacturing processes described reduce the possibility of damaging the sensing structure during the steps of opening the inlet holes as they are vertically offset with respect to the coupling holes: coupling holes and inlet holes of the sensor are in fact opened in distinct steps of the manufacturing process. Furthermore, as anticipated, the processing of the cap in order to create the structures described is independent of the processing of the supporting body and the elements that the supporting body accommodates. In particular, the manufacturing processes described are independent of the wafer-to-wafer bonding technology implemented (for example, thermal bonding or glass-frit bonding).

Finally, it is clear that modifications and variations may be made to what has been described and illustrated herein without thereby departing from the scope of the present invention, as defined in the attached claims.

For example, the sensing structure may comprise more than one piezoelectric membrane and/or elements sensitive to pressure variations of a nature different from what has been shown. More generally, the sensing structure may be different and may be capable to sensing different physical quantities, such as, for example, humidity.

Furthermore, the inlet holes and the coupling holes of the pressure sensor may be different from what has been shown, for example may have different geometry and/or be in different number and/or organized in a different geometric arrangement in the cap: the inlet holes may be for example organized in three rows surrounding the sensing structure on three distinct sides; or, the coupling holes may be arranged in more external positions of the pressure sensor with respect to the inlet holes; the vertical traps may also be in a different number than what has been shown or may be absent.

Still fulfilling the filtering function, the filtering structures may be different from what has been previously described: for example, the filtering structures may have geometries which in cross-section and in top-plan view are different from those shown in the attached Figures; or, the filtering structures may be defined by a combination of the embodiments shown. The rerouting cavity may also comprise ("in-plane" or "out-of-plane") trapping elements and may be devoid of filtering structures.

The bonding ring useful for bonding the cap to the supporting body may be of any type (for example of metal material, with AlGe or AuAu compounds). Or, the cap may be defined on its surface arranged facing the supporting body so as to comprise cantilever elements which, once coated with a bonding layer (for example a germanium-aluminum layer), allow the supporting body to be bonded in dedicated positions.

The supporting body may also comprise structures for trapping contaminants coming from the external environment, such as for example trenches trenched into the supporting body and/or defined at least partially in the separation region, to further reduce the probability that such contaminants reach the sensing structure.

As regards the manufacturing process of the sensor of the present invention, it is understood that the step of bonding the cap wafer to the sensor wafer and the step of forming the plurality of inlet holes in the cap wafer may be reversed in the order of execution obtaining the same advantages described.

## Claims

1. A microelectromechanical sensor (1; 50) comprising:
- a supporting body (2), containing semiconductor material;
- a sensing structure (6), comprising a measuring chamber (9) and a sensitive element (8), the sensitive element (8) being formed at least partially in the supporting body (2) and facing the measuring chamber (9); and
- a cap (3), of semiconductor material, coupled to the supporting body (2) and having an internal surface (3a), arranged facing the supporting body (2), and an external surface (3b), opposite to the internal surface (3a) along a first direction (Z),
wherein the cap (3) comprises a buried cavity (10; 60), a plurality of inlet holes (5), communicating with the environment external to the sensor and with the buried cavity (10; 60), and a plurality of coupling holes (15), communicating with the measuring chamber (9) and with the buried cavity (10; 60),
wherein the plurality of inlet holes (5) is in fluidic communication with the plurality of coupling holes (15) by the buried cavity (10; 60), and
wherein the inlet holes (5) are offset with respect to the coupling holes (15).

2. The sensor (1; 50) according to claim 1, wherein the buried cavity (10; 60) extends in the cap (3) perpendicular to the first direction (Z).

3. The sensor (1; 50) according to claim 1 or 2, wherein the inlet holes (5) extend parallel to the first direction (Z) from the external surface (3b) at least to the buried cavity (10; 60), and wherein the coupling holes (15) extend parallel to the first direction (Z) from the internal surface (3a) at least to the buried cavity (10; 60).

4. The sensor (50) according to any of the preceding claims, wherein the buried cavity (60) comprises filtering structures (65) fluidically interposed between the inlet holes (5) and the coupling holes (15).

5. The sensor (50) according to the preceding claim, wherein each filtering structure (65) comprises a plurality of barrier elements (66) arranged so as to create tortuous fluidic paths between respective inlet holes (5) and the plurality of coupling holes (15).

6. The sensor (50) according to the preceding claim, wherein the barrier elements (66) have an elongated shape parallel to a second direction (Y), are offset to each other along a third direction (X) and have a height, parallel to the first direction (Z), equal to a height (H) of the buried cavity (60), the second and the third directions (Y, X) being perpendicular to each other and perpendicular to the first direction (Z), and
wherein each filtering structure (65) further comprises fluidic openings (66a; 66b), between adjacent barrier elements (66), offset at least parallel to the second direction (Y).

7. The sensor (50) according to any of claims 4 to 6, wherein each filtering structure (65) includes trenches which develop, in a plane (XY) perpendicular to the first direction (Z), according to folded arms, so as to create tortuous fluidic paths between respective inlet holes (5) and the plurality of coupling holes (15).

8. The sensor (1; 50) according to any of the preceding claims, wherein the buried cavity (60) further comprises trapping elements (67) defined by trenches extending parallel to a plane (XY), perpendicular to the first direction (Z), and/or parallel to the first direction (Z).

9. The sensor (1; 50) according to any of the preceding claims, further comprising a platform (20), suspended with respect to the supporting body (2) and accommodating the sensing structure (6) at least partially, and
wherein the sensing structure (6) is sensitive to pressure variations and comprises a reference chamber (7) sealed at a reference pressure, and wherein the sensitive element comprises a membrane (8) interposed between the reference chamber (7) and the measuring chamber (9); the reference chamber (7) being a cavity buried in the supporting body (2), and the measuring chamber (9) being delimited by the supporting body (2) and the cap (3) and being in fluidic coupling with the environment external to the sensor through the cap (3).

10. A process for manufacturing a microelectromechanical sensor (1; 50) comprising:
- in a supporting body (2), containing semiconductor material, defining a sensing structure (6) comprising a surface sensitive element (8);
- in a cap (3), of semiconductor material and having an internal surface (3a) and an external surface (3b), opposite to the internal surface (3a) along a first direction (Z), forming a buried cavity (10; 60) and, on the internal surface (3a), a plurality of coupling holes (15) communicating with the buried cavity (10; 60);
- bonding the cap (3) to the supporting body (2) so as to define a measuring chamber (9) between the cap (3) and the supporting body (2), with the sensitive element (8) facing the measuring chamber (9), and so that the coupling holes (15) communicate with the measuring chamber (9); and
- forming, on the external surface (3b) of the cap (3), a plurality of inlet holes (5) communicating with the buried cavity (10; 60), so that the plurality of inlet holes (5) is in fluidic communication with the plurality of coupling holes (15) by the buried cavity (10; 60),
wherein the inlet holes (5) are offset with respect to the coupling holes (15).

11. The manufacturing process according to claim 10, comprising forming, in the buried cavity (60), filtering structures (65) fluidically interposed between the inlet holes (5) and the coupling holes (15).

12. The manufacturing process according to the preceding claim, wherein forming the filtering structures (65) comprises forming a plurality of barrier elements (66) arranged so as to create tortuous fluidic paths between respective inlet holes (5) and the plurality of coupling holes (15), the barrier elements (66) having a height, parallel to the first direction (Z), equal to a height (H) of the buried cavity (60).

13. The manufacturing process according to the preceding claim, wherein the barrier elements (66) further have an elongated shape parallel to a second direction (Y) and are offset to each other along a third direction (X), the second and the third directions (Y, X) being perpendicular to each other and perpendicular to the first direction (Z), and
wherein each filtering structure (65) further comprises fluidic openings (66a; 66b), between adjacent barrier elements (66), offset at least parallel to the second direction (Y).

14. The manufacturing process according to any of claims 10 to 13, wherein forming the buried cavity (10; 60) comprises etching the cap (3), performing an epitaxial growth and an annealing in a reducing environment, before forming the plurality of coupling holes (15).

15. The manufacturing process according to any of claims 10 to 13, wherein forming the coupling holes (15) and the buried cavity (10; 60) comprises:
- forming a sacrificial layer (302) on a substrate (301) of semiconductor material;
- opening trenches (305a) in the sacrificial layer (302) in positions corresponding to the coupling holes (15);
- forming a structural layer (303) of semiconductor material on the substrate (301) and on the sacrificial layer (302), filling the trenches (305a) and creating the internal surface (3a) of the cap (3);
- selectively etching the internal surface (3a) to open the coupling holes (15); and
- removing the sacrificial layer (302) through the coupling holes (15), releasing the buried cavity (10; 60).

16. The manufacturing process according to the preceding claim when dependent on any of claims 11 to 13, further comprising opening further trenches (305) in the sacrificial layer (302) in positions corresponding to the filtering structures (65), and wherein forming the structural layer (303) comprises filling the further trenches (305) creating the filtering structures (65).
